Europäisches Patentamt

European Patent Office

Office européen des brevets

(11) Publication number: **0 401 848**
**A2**

## EUROPEAN PATENT APPLICATION

(21) Application number: **90110876.1**

(22) Date of filing: **08.06.90**

(51) Int. Cl.5: **H01L 23/498, H01L 21/66**

(30) Priority: **09.06.89 JP 148053/89**

(43) Date of publication of application:
**12.12.90 Bulletin 90/50**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Yoshida, Akito, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Tape carrier and test method therefor.

(57) A tape carrier comprises contact test patterns ($3_1$, $3_2$) used for performing a conduction test on a tape base (2). More specifically, in addition to test pads (3) connected to outer leads used for input/output signals, the contact test patterns ($3_1$, $3_2$) are formed on the tape base to test whether socket contactors (11) are in contact with the test pads (3). A conduction test is performed using the contact test patterns. The tape is repeatedly reset to the socket until a conductive state is established, thereby preventing a test error.

FIG. 4

Xerox Copy Centre

**Tape carrier and test method therefor**

The present invention relates to a structure of a tape carrier which is one of semiconductor packages, and a method of testing to discriminate a non-defective tape carrier from a defective tape carrier.

A tape carrier is wound in a reel-like shape.

When a test for discriminating a non-defective tape carrier from a defective tape carrier is to be conducted, the tape carrier is pulled by a predetermined length, and the pulled portion is tested using a probe card.

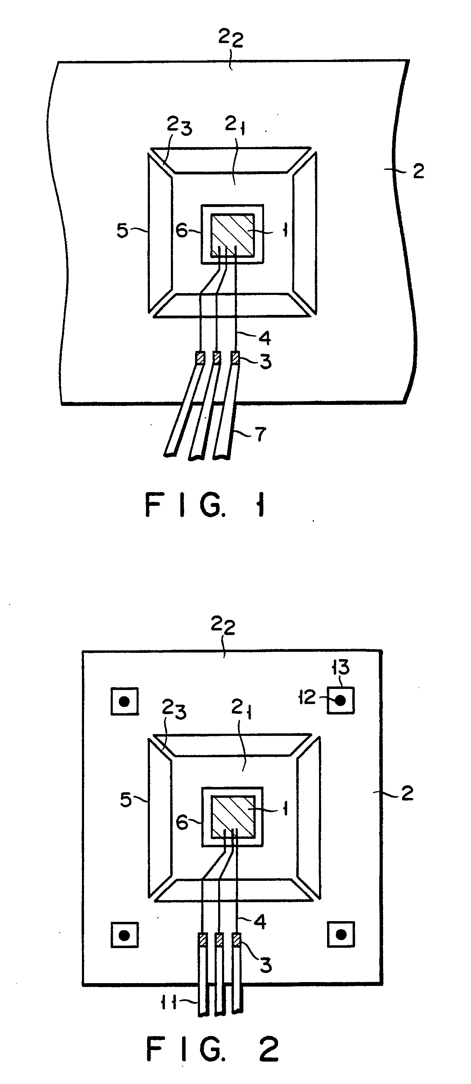

In a test, as shown in Fig. 1, probe card pins 7 are pressed on test pads 3 of the tape carrier by a press member (not shown). Reference numeral 1 in Fig. 1 denotes a semiconductor chip; 2, an insulating tape base; 3, a test pad formed on the tape base 2; and 4, a lead member for connecting the chip 1 to the test pad 3. Although only three pads and three lead members are illustrated in Fig. 1, other pads and the corresponding lead members are usually arranged. Reference numeral $2_3$ denotes a support tape for connecting an insulating tape $2_1$ on the package and an insulating tape $2_2$ on the outer frame; 5, a cavity formed between the tapes $2_1$ and $2_2$ for separating the package; 6, a cavity in which the chip 1 is disposed; and 7, a probe card pin.

However, it is impossible to apply a burn-in technique (i.e., a technique for making a substantially defective component perfectly defective, by applying to the semiconductor chip a large stress, for example, a high voltage) to the tape carrier of such a structure as shown in Fig. 1.

In recent years, as shown in Fig. 2, individual tape carriers are cut from each other, and the burn-in operation and testing are performed for each unit tape carrier by using sockets. Reference numeral 11 denotes a contactor (socket pin) of a socket (not shown); 12, a tape positioning guide pin (socket pin) projecting from a socket board (not shown); and 13, a cavity (tape guide hole) formed in the tape $2_2$. Each guide pin 12 extending from the socket board is inserted into the corresponding tape guide hole 13 of the tape $2_2$.

In the second conventional case, several tens of sockets are aligned in a burning-in rack (not shown) in a matrix form, unit tape carriers are attached to the corresponding sockets, and a high voltage is applied to the test pads 3 of each tape carrier through contactors 11 of a socket, thereby performing a simultaneous burn-in operation for these tape carriers.

A socket of the same type as that used in the burn-in process can be used to perform a function test.

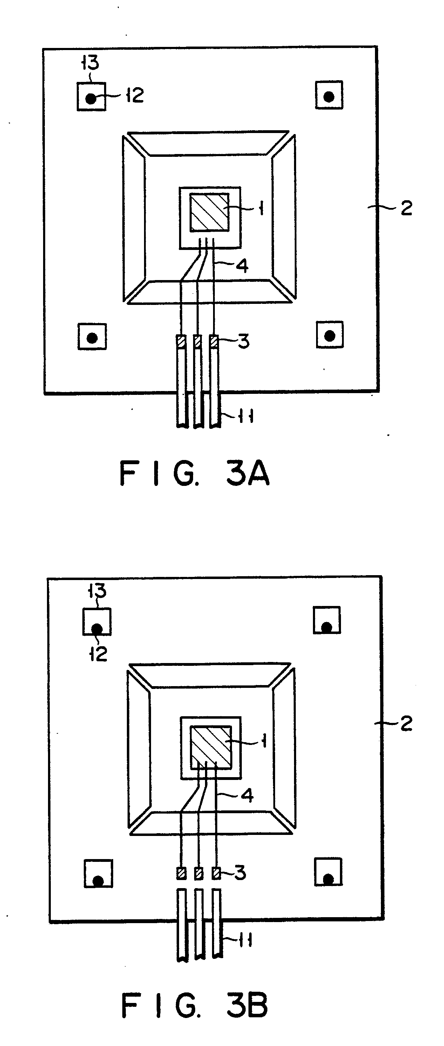

In the burn-in process or the function test, the socket contactors must be in contact with the test pads. However, this assumption is not necessarily satisfied in a conventional test. For example, as shown in Fig. 3B, when the guide pins 12 are set with deviation from the centers of the corresponding guide holes 13, the contactors 11 are often disconnected from the corresponding test pads 3 by this deviation. In this case, the package itself is not defective, but the test operation is unsatisfactory.

Fig. 3A shows another example in which the tape package itself is defective. In this example, the semiconductor chip 1 is deviated from a predetermined position, and the test leads 4 are disconnected from the semiconductor chip 1, so that a closed circuit of socket contactors 11 and test pads 3 cannot be formed. In this case, the function test result shows that the tape carrier is defective.

There are three cases for detecting a sample package as a defective package in the function or discrimination test.

(1) The package itself is not defective, but the test is unsatisfactory (Fig. 3B).

(2) The test is satisfactory, but the package itself is defective (the term "satisfactory" means that the pad 3 is in contact with the contactor 11) (Fig. 3A).

(3) The package itself is defective and the test is also unsatisfactory (combination of the cases shown in Figs. 3A and 3B).

In case (1), although the package is actually non-defective, the test is unsatisfactory so that the non-defective package is conventionally discriminated as a defective package and is wasted.

It is an object of the present invention to provide a structure of a tape carrier which allows easy discrimination of a contact state between a tape carrier test pad and a socket contactor and a method of testing to correctly discriminate a non-defective tape carrier from a defective tape carrier so as to prevent tape carriers from wasting as defective tape carriers.

According to the present invention, there is provided a tape carrier comprising:
a tape base; and
a contact test patterns formed on said tape base, used for performing a conduction test.

According to the present invention, there is further provided a method of testing a tape carrier including a tape base and a contact test patterns formed on said tape base, used for performing a conductiont test, comprising a step of performing a conduction test of said contact test patterns when a non-defective/defective discrimination test is performed for the tape carrier.

The present invention is characterized by forming contact test patterns used for performing a conduction test on a tape base. More specifically, in addition to test pads connected to outer leads used for input/output signals, contact test patterns are formed on the tape base to test whether socket contactors are in contact with the test pads. A conduction test is performed using the contact test patterns. The tape is repeatedly reset to the socket until a conductive state is established, thereby preventing a test error.

This invention can be more fully understood from the following detailed description when taken in conjunction with the accompanying drawings, in which:

Fig. 1 is a plan view of a conventional tape carrier;

Fig. 2 is a plan view showing another conventional tape carrier;

Figs. 3A and 3B are plan views showing conventional tape carriers in a test mode for testing a non-defective tape carrier from a defective tape carrier;

Fig. 4 is a plan view showing a tape carrier according to an embodiment of the present invention;

Fig. 5 is a plan view showing a tape carrier in a test mode for testing a non-defective tape carrier from a defective tape carrier;

Fig. 6 is a plan view showing a tape carrier according to another embodiment of the present invention;

Fig. 7 is a flow chart of a test for discriminating a non-defective tape carrier from a defective tape carrier according to the present invention; and

Fig. 8 is a plan view showing a tape carrier in a test mode for testing a non-defective tape carrier from a defective tape carrier.

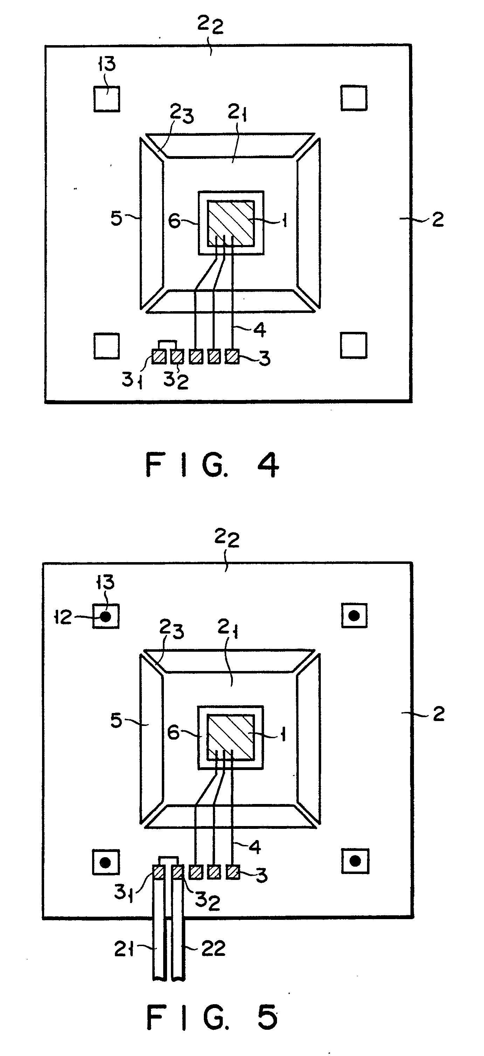

An embodiment of the present invention will be described with reference to the accompanying drawings. Since this embodiment corresponds to the conventional example shown in Fig. 2, the same reference numerals as in Fig. 2 denote the same parts in Fig. 4. Reference numeral 1 denotes a semiconductor chip; 2, an insulating tape base; 3, a test pad formed on the tape base 2; and 4, a lead member for connecting the chip 1 and the test pad 3. Although only three pads and three lead members are illustrated, other pads and lead members are usually arranged. Reference numeral $2_3$ denotes a support tape for connecting an insulating tape $2_1$ on the package and an insulating tape $2_2$ on the outer frame; 5, a cavity formed between the tapes $2_1$ and $2_2$ for separating the packages; 6, a cavity for receiving the chip 1; and 7, a probe card pin.

According to a characteristic feature of this embodiment, contact test patterns $3_1$ and $3_2$ are formed on the insulating tape $2_2$ on the outer frame, and arranged in alignment with the test pads 3. The contact test patterns are adjacent and connected to each other, and made of, for example, copper.

When the tape carrier is subjected to a function test or a burn-in process, the tape carrier is first set on a test socket board, as shown in Fig. 5, to bring test pins 21 and 22 into contact with the test patterns $3_1$ and $3_2$ to perform a conduction test of the patterns $3_1$ and $3_2$ and the test pins 21 and 22. The test pins 21 and 22 are arranged in alignment with the test contactors 11 of the test socket. The test result is detected by a test circuit. For example, when a conductive state or conduction is not established, no current flows through the patterns $3_1$ and $3_2$ and test pins 21 and 22. Thus, whether the conductive state has been established is determined by detecting the presence/absence of the current. When a non-conduction is established, the tape 2 is reset on the socket board, and the same measurement is repeated. By repeating the above operations, the conductive state can be established. Thereafter, a function test or burn-in process is performed. Establishment of conduction means that the tape carrier is set at a predetermined position on the socket board. The conduction establishment also means that the contactors 11 of the socket are in contact with the test pads 3, since the contact test patterns $3_1$ and $3_2$ align with the test pad 3, and the test pins 21 and 22 align with the contactors 11.

Specifically, when the tape carrier is subjected to a function test or a burn-in process, the tape carrier is first set on a socket, with the guide holes 13 of the tape carrier into which the guide pins 12 of the socket are inserted. According to the present invention, in this state, a conduction test is performed. Specifically, contact test pins 21 and 22 are set on predetermined positions of the socket. When the tape carrier is set at a predetermined position on the socket, the contact test pins 21 and 22 are in contact with the contact test patterns $31_1$ and $31_2$. With the contact test pins being in contact with the test patterns, a conduction is established between them, and current flows through the test patterns and the test pins. This means that the contactors 11 are in contact with the test pads 3 of the tape carrier. After the conduction is established, the function test or the burn-in process is carried out. Since, in this time, the contactors 11 have been in contact with the test pads 3, the function test or the burn-in of the semiconductor chip can be correctly performed.

When, however, the tape carrier is set on the socket with deviation from the predetermined position, the contact test pins 21 and 22 are not in contact with the contact test patterns $3_1$ and $3_2$. Thus, conduction is not established between them, and no current flows through the test patterns and the test pins. This means that the contactors 11 are out of contact with the test pads 3 of the tape carrier. The non-conduction can be detected using a conduction test circuit (not shown) by determining whether current flows through the test patterns and the test pins. In this case, the tape carrier is reset on the socket and is again subjected to the conduction test. This operation is repeatedly performed until the conduction is established. When the conduction is established, then the function test or the burn-in process is carried out. Since, in this time, the contactors 11 have been in contact with the test pads 3, the function test or the burn-in of the semiconductor chip can be correctly performed.

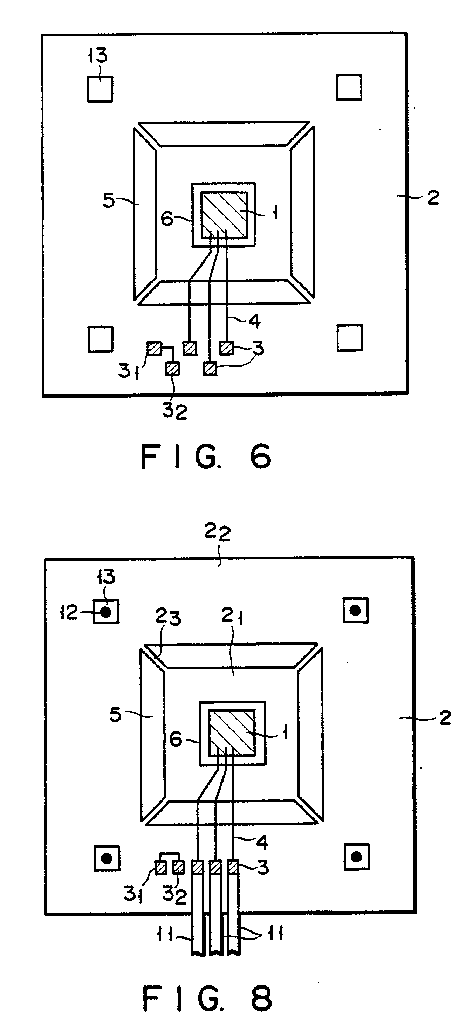

The shape and position of the contact test patterns are not limited to specific ones if it can be formed on the tape. For example, as shown in Fig. 6, the contact test patterns $3_1$ and $3_2$ and test pads 3 may be arranged in a stagger fashion. However, in this case, the conduction test pins and the contactors of the socket must be arranged to correspond to the stagger fashion of the contact test patterns and the test pads.

In all the embodiment, since the patterns $3_1$ and $3_2$ can be formed together with the pads 3, the manufacturing process cannot be complicated, and no alignment-tolerance is present between the patterns $3_1$ and $3_2$ and the test pads 3.

Although the position of the contact test patterns is not limited to a specific one, a corner position of the tape $2_2$ is preferable because a maximum aligning error occurs at a corner position.

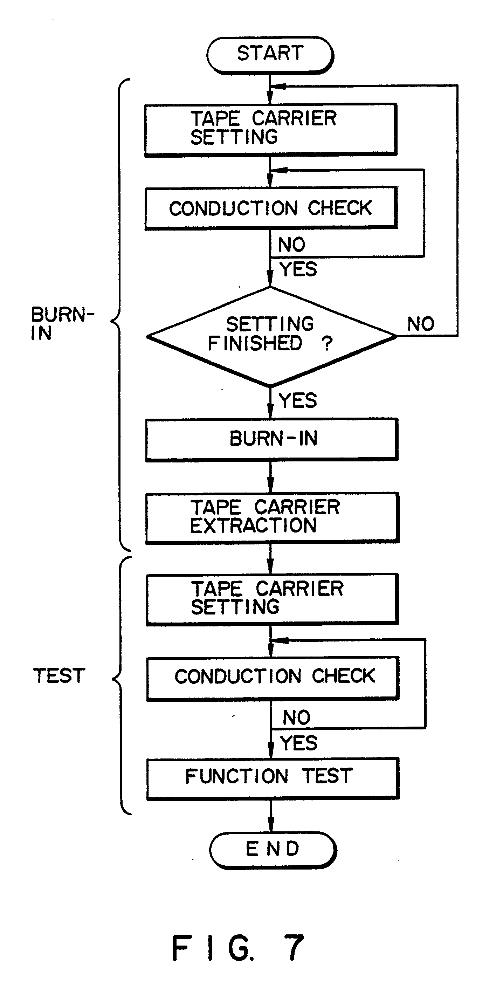

According to a test method of this embodiment, as shown in a flow chart of Fig. 7, a tape carrier is first set on a burning-in socket board, and it is checked if the test pins 21 and 22 of a conduction test circuit (not shown) are in contact with the contact test patterns $3_1$ and $3_2$ (conduction check). If conduction is not established, the tape carrier is reset on the socket, and conduction is checked again. This operation is repeatedly performed until the conduction is established. After the conduction has been established, another tape carrier is set on another burning-in socket, and the same operation is performed for this tape carrier. After conduction has been established for this tape carrier, a further tape carrier is set on a further burning-in socket, and the above operation is carried out to the further tape carrier. In this way, predetermined number of tape carries are correctly set on the burning-in sockets of a burning-in socket board. After the setting of the predetermined number of tape carriers has been finished, a burn-in process is performed. In this time, the test pads 3 of each tape carrier are in contact with the socket contactors 11, as shown in Fig. 8. Thus, the burn-in process can be correctly performed. After the burn-in of the tape carries has been completed, the tape carriers are extracted form the socket board. Thereafter, for the function test, each tape carrier is set on a testing socket, and subjected to the conduction test. When conduction is not established, the tape carrier is reset on the socket, and the conduction test is again performed. This operation is repeatedly performed until the conduction is established. After the conduction is established, the function test is carried out. In this time, since the socket contactors 11 are in contact with the test pads 3, the function test is correctly performed. When the function test result shows that the tape carrier is normally operative, the tape carrier is regarded as a non-defective package. In this way, the tape carrier is correctly tested.

As described above, according to the present invention, prior to performing of the burn-in process, the conduction test has been carried, and after conduction has been established, the burn-in of the tape carrier is carried out. In this time, since the socket contactors 11 are in contact with the test pads 3, the burn-in process is correctly performed. Similarly, prior to performing of the function test, the conduction test has been carried, and after conduction has been established, the function test of the tape carrier is carried out. In this time, since the socket contactors 11 are in contact with the test pads 3, the function test is correctly performed.

As has been described above, according to the present invention, there are provided a structure of a tape carrier wherein the contact state between the tape carrier test pad and the socket contactor can be easily identified, and a method of testing to discriminate a non-defective tape carrier from a defective tape carrier so as to prevent a detection error for a non-defective tape carrier as a defective tape carrier.

Reference signs have been added to the claims for reference purposes only and do not alter the scope.

## Claims

1. A tape carrier comprising:
a tape base (2); and
a contact test patterns ($3_1$, $3_2$) formed on said tape base, used for performing a conduction test.

2. A tape carrier according to claim 1, characterized in that said contact test patterns ($3_1$, $3_2$) are formed near a corner of said tape base.

3. A tape carrier according to claim 1, characterized in that said contact test patterns ($3_1$, $3_2$)

are formed in a process in which other patterns (3) are formed on said tape base.

4. A method of testing a tape carrier including a tape base (2) and a contact test patterns ($3_1$, $3_2$) formed on said tape base (2), used for performing a conduction test, comprising a step of performing a conduction test of said contact test patterns when a non-defective/defective discrimination test is performed for the tape carrier.

22

23  21

5  6  —1

4

3

7

F I G. 1

22

13

12

23  21

5

6  —1

4

3

11

F I G. 2

EP 0 401 848 A2

F I G. 3A

F I G. 3B

F I G. 4

F I G. 5

EP 0 401 848 A2

F I G. 6

F I G. 8

F I G. 7